# EUROPEAN PATENT APPLICATION

(11) **EP 1 868 002 A1**
(43) Date of publication of application: **19.12.2007**
(21) Application number: 07019609.2
(22) Date of filing: 07.07.2005
(51) Int. Cl.: G01R 31/02

(54) **Apparatus for position detection**

(30) Priority: 19.07.2004 US 588744 P
(62) Divisional of application: 05758954.1
(71) Applicant: Kodak IL Ltd., 46103 Herzlia (IL)
(72) Inventor: Burkatovsky, V, 46103 Herzlia (IL)
(74) Representative: Lee, Brenda

(57) **Abstract**

Apparatus and method for detection of disconnect and faulty connection in signal lines, between system's electronic controller and system known in the art peripheral devices, such as photo interrupters, magnetic sensors, or limit detectors, having a common feature, namely, their mode of performance, as signaled to the electronic controller - Contact Open - Contact Close, or Voltage High - Voltage Low. The modified, per the invention, circuitry at the output of the peripheral devices result in a novel configuration of a two signal line device, having a scaled output voltage range. When connected to the "decision module" of an electronic controller, the controller can distinguish between the useful scaled output voltage range and faulty conditions of an open connection wire or a shorted to ground one.

One preferred embodiment of the invention is a novel two-line digital position detector, based on the interruption of an optical coupling between a light-emitting diode and a phototransistor.

## Description

### FIELD AND BACKGROUND OF THE INVENTION

The present invention relates to methods of system configuration diagnostics, and more specifically to detection of disconnect and faulty connection in signal lines or wires, between a system's electronic controller and system peripherals.

Electronic control and automation systems use peripheral devices such as photo interrupters, magnetic sensors, or limit detectors, having a common feature, namely, their mode of performance, as signaled to the electronic controller: Contact Open - Contact Close, or Voltage High - Voltage Low.

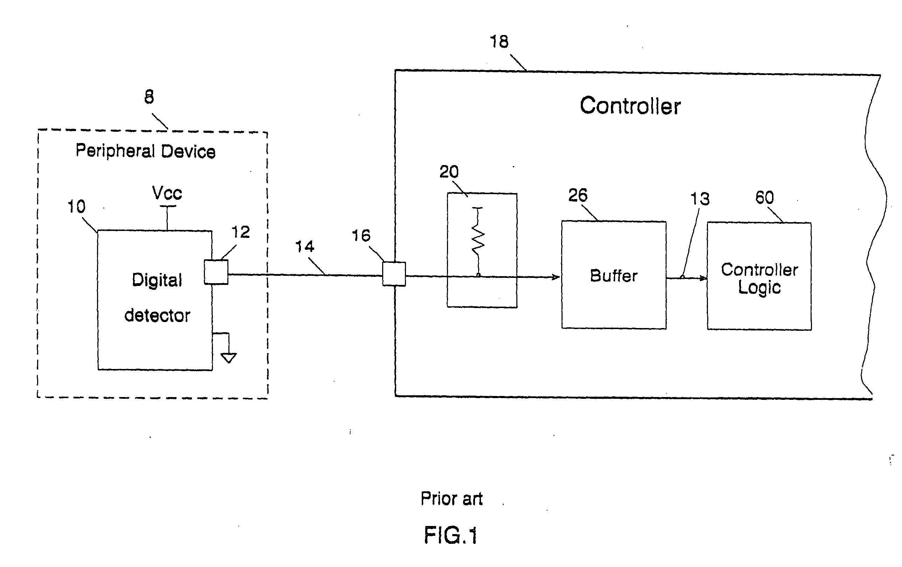

Fig.1 is a general block diagram showing a prior-art interconnection scheme between the electronic controller 18 and one of its peripheral devices 8.

The peripheral device 8, implemented, for example, as a digital detector 10, is connected via the digital detector output pin 12 and the signal line or wire 14 to the input pin 16 of the controller 18, to pull-up resistor 20 as well as to the input of buffer 26. The output of buffer 26 is connected to controller logic 60.

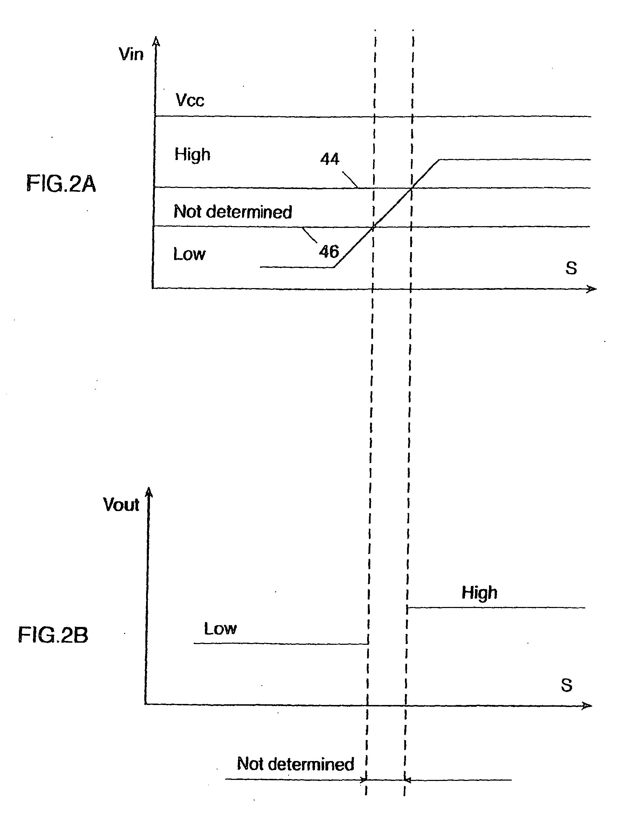

Under normal conditions, when digital detector 10 is properly connected to controller input 16, the signal information received from the peripheral device 8 at buffer 26 will be true. Fig.2B shows the voltage zones of output signal Vout, at the output 13 of buffer 26, defined in the art - Logic Low or High, as a function of changes in an input parameter S (for example, the position of an object) detected by the digital detector 10.

The problems start when normal conditions are disrupted:
a) In case of signal line 14 disconnection (between detector output pin 12 and controller input pin 16) the signal at the input of the buffer 26 will be a logic "High", determined only by the pull-up resistor 20, and not by the true output of the peripheral device 8.
b) Fig. 2A shows the signal value Vin at the input 16 to buffer 26, as a function of an input parameter S (for example, object position) detected by the digital detector 10. If Vin- for reasons such as object position S, faulty connection or overloaded interconnection line- is in the range between voltage levels 44 and 46, then, because of the buffer 26 threshold variance (or input hysteresis), the buffer output signal 13 can be interpreted as logic High or logic Low. This creates a "not determined" Vin zone, which is considered unacceptable for the Controller Logic 60.

US patent 6,687,140 describes one method for solving the disconnection detection problem, by providing switches and control means for controlling such switches. The switches set the detection signal, to be supplied to the signal line; the status, whether there is a disconnection state in the signal line -or not- is judged on the basis of a change in the detection signal.

The disadvantage of this method is the limited range of peripheral devices served, and inability to detect fault conditions such as signal line "short to Ground" or "short to Vcc".

### OBJECTS AND BRIEF SUMMARY OF THE PRESENT INVENTION

An object of the present invention is to provide an apparatus and also a method for verification of signal lines between a system's electronic controller and system peripheral devices. Another object of the present invention is to facilitate connection of said peripheral device to said electronic controller by two signal wires only.

According to one aspect of the present invention, a voltage divider is connected to the output of a digital detector to form a system peripheral device. The voltage divider is a combination of resistors and diodes, and can be incorporated in the digital detector or connected external to same detector.

According to another aspect of the present invention, the electronic controller includes a "decision module", comprising of a converter of line voltage signals to digital or time dependent parameters, and signal acquisition logic, providing a decision function as to the state of the signal lines.

By adding the voltage divider, the decision-module, being connected to the peripheral device by means of signal lines or wires, can distinguish between four distinctive signal states: Logic High, Logic Low, Disconnected Line and Shorted Line. The first two states are useful for the normal operation mode of the peripheral device, while the two other states signal a failure in the connection lines.

One preferred embodiment of the invention is a novel two-line digital position detector, based on the interruption of an optical coupling between a light-emitting diode and a phototransistor. The application of the voltage divider in this embodiment reduces the current consumption of the peripheral device, and enables sharp logic transitions due to built-in hysteresis effect.

### BRIEF DESCRIPTION OF THE DRAWINGS

The invention is herein described, by way of example only, with reference to the accompanying drawings, wherein:
Fig. 1 is a general block diagram of a prior-art interconnection scheme between an electronic controller and one of its peripheral devices.
Fig. 2A and 2B are schematic diagrams showing specific voltage levels as a function of an input parameter.
Fig. 3 is a general block-diagram describing the preferred embodiment of the invented interconnect verification method.
Fig. 4 is a schematic interconnection diagram to the controller "decision module" of a sample peripheral device, based on a digital detector.
Fig. 5 is a schematic diagram showing the output voltage range of the digital detector of Fig. 4 and the scaled peripheral device output voltage range as a function of an input parameter.
Fig. 6 is a schematic interconnection diagram to the controller "decision module" of a sample peripheral device based on a digital detector having an "open collector".
Fig. 7 is a schematic interconnection diagram to the controller "decision module" of a sample peripheral device including a digital detector based on a photo-interrupter.
Fig. 8 is a schematic comparison of power consumption by the proposed circuitry of Fig.7 to a conventional peripheral device configuration.
Fig. 9 is a schematic diagram demonstrating the bi-stable hysteresis effect of the proposed circuitry of Fig. 7.

### DESCRIPTION OF PREFERRED EMBODIMENTS

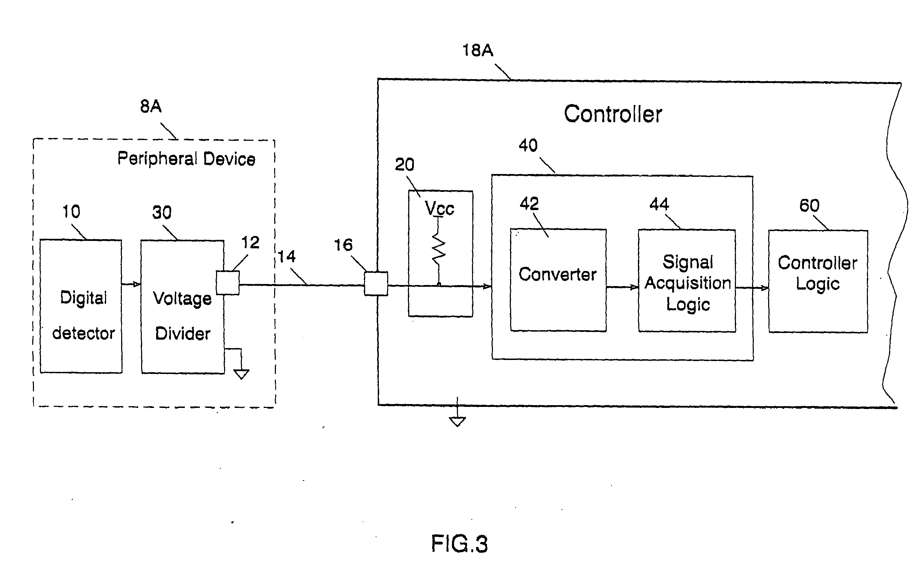

Fig.3 is a general block- diagram describing the preferred embodiment of the invented interconnect verification method.

The method aims at a better verification of the status of signal line 14, connecting output pin 12 of peripheral device 8A and input pin16 of controller 18A. For this purpose the peripheral device 8A consists of a known-in-the-art digital detector 10 followed by a voltage divider 30, which is part of the invention.

Signal line 14 interconnects, therefore, the output of voltage divider unit 30 to pin 16, conventionally connected to pull-up resistor 20, and to a "decision module" 40. This module consists, for example, of "converter" 42, providing conversion of signal line voltage to digital or time dependent parameters, and a "signal acquisition logic" 44 providing a "decision" function as to the converter's output. The "decision" result is fed to known-in-the-art controller logic 60 for further processing. Such a "decision module" 40 is described, for example, in WO 2005/029207 by the same inventor.

The interconnect verification method will be demonstrated by examples of typical signal line faults between controller 18 and a peripheral device 8A.

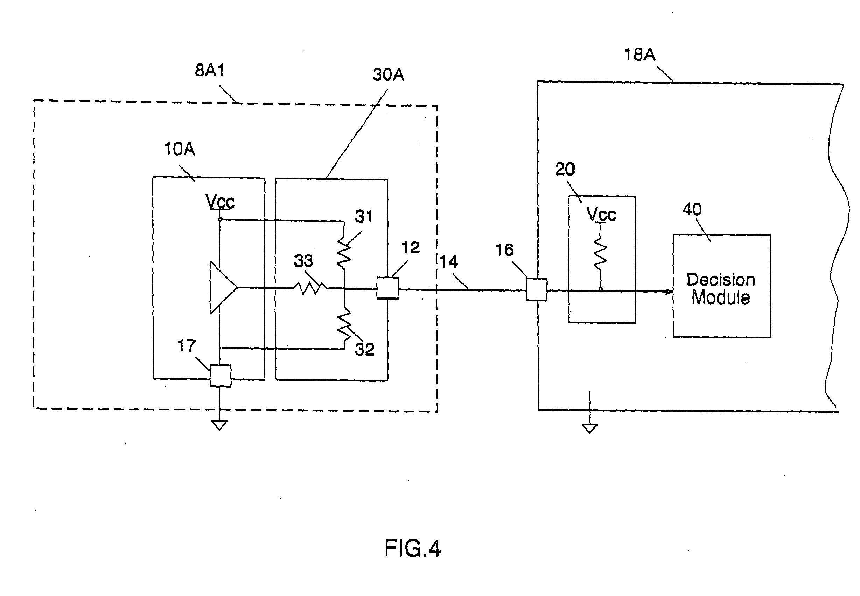

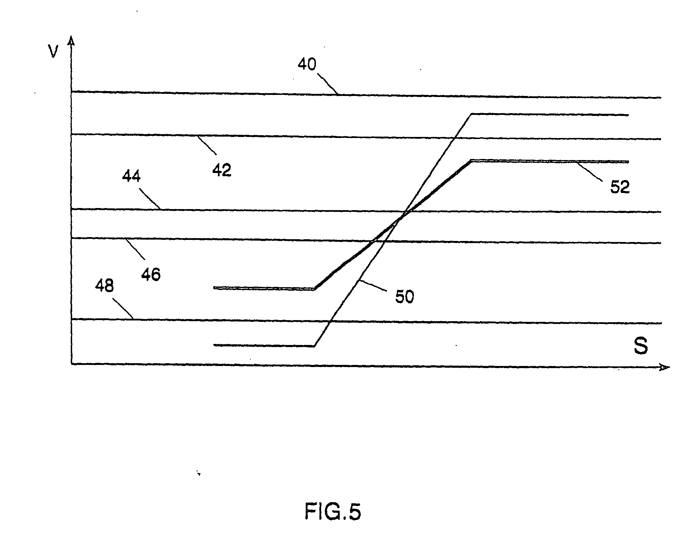

Fig.4 shows the interconnection of a peripheral device 8A1 based on digital detector 10A having a voltage source output, such as, for example, a 3-wire totem-pole output slotted optical switch OPB120A of Optek Technology, Inc., 1215 W Crosby Road Carrollton, Texas 75006. This type of detector 10A will have an output voltage close to Vcc, for the High logic state, and a voltage value close to ground, when in the Low logic state. The voltage divider 30A consist of resistors 31, 32 and 33 connected as shown, in purpose to scale the detector 10A output voltage and shift the scaled range to the middle of the supply voltage range. The preferable scaling factor is: SF = 0.7 - 0.8. The detector 10A output voltage range 50 and the scaled peripheral device output voltage range 52 (at pin 12 of device 8A1) are shown in Fig.5

If the peripheral device 8A1 is properly connected to the controller 18A, then the "decision module" 40 will receive as an input at pin 16 a voltages signal in the range between the minimum available output voltage of the peripheral device (marked 48 in Fig.5) and the maximum available output voltage marked 42. We will mark voltage level 48 as the shift value Vsh, and then, the input signal to pin 16 will be in the range of: Vcc X SF to Vsh.

The "decision module" 40 will consider the signal at its input pin 16 as logic High or Low, as follows:
- If the input signal is between voltage level 48 and a low threshold value 46 - Logic Low
- If the input signal is between voltage level 42 and a high threshold value 44 - Logic High
- The signals between threshold value 44 and threshold value 46 will be interpreted as not reliable or weak signals.

The following abnormal cases are considered:
A. If line 14 is disconnected, then the resistor 20 of controller 18A will pull up the input at pin 16 to Vcc level. In this case the "decision module" 40 will determine the status as "Disconnected Line", as the signal value at its input 16 is above the maximum value 42 of the peripheral device 8 output.
B. When signal line 14 is shorted to ground, the signal value on the input pin 16 will be equal to zero. In this case the "decision module" 40 will determine the status as "Shorted Line", as the signal value at its input 16 is below the minimum value 48 of device 8A1 output.

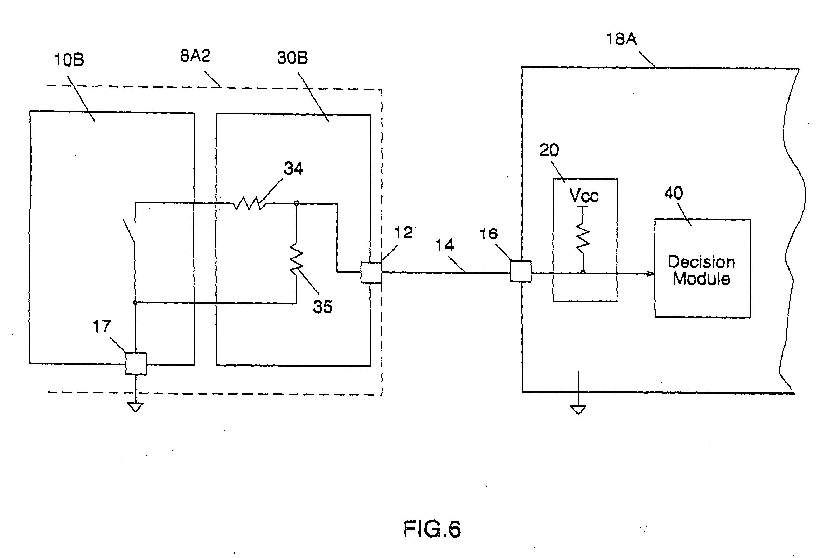

Another example describes in Fig.6 relates to a peripheral device 8A2 based on a two-wire digital detector 10B having an open collector, such as the SHARP GP1 L57 photo-interrupter (not shown) or the switch type output (as shown in Fig.6).

In this case, the voltage divider 30B is implemented by resistors 34 and 35, connected as shown. The purpose of the voltage divider is the same as in Fig. 4, namely, to scale and shift the range of peripheral device output voltage.

Under normal conditions when peripheral device 8A2 is properly connected to the controller 18 and detector 10B is in its OFF state (open switch), the voltage applied to the input 16 of "decision module" 40 is determined by values of resistor 35 and pull-up resistor 20. The voltage level defined by resistors 35 and 20 is the maximum available output voltage level of the peripheral device (line 42 in Fig.5), and the "decision module" 40 will interpret the signal between voltage level 42 and threshold 44 as logic High.

When the detector 10B of peripheral device 8 is in its ON state (closed switch), the voltage applied to the input 16 of "decision module" 40 is determined by values of resistors 34, 35 and 20. The parallel connection of resistors 34 and 35 with series connected resistor 20 determines the minimum available output value 48 of Fig. 5.

The "decision module" 40 will interpret the peripheral device output voltage signal, having values between minimum available voltage level 48 and low limit threshold 46 as logic Low.

The detection of disconnected or shorted to ground line 14 is performed exactly as described in the previous example.

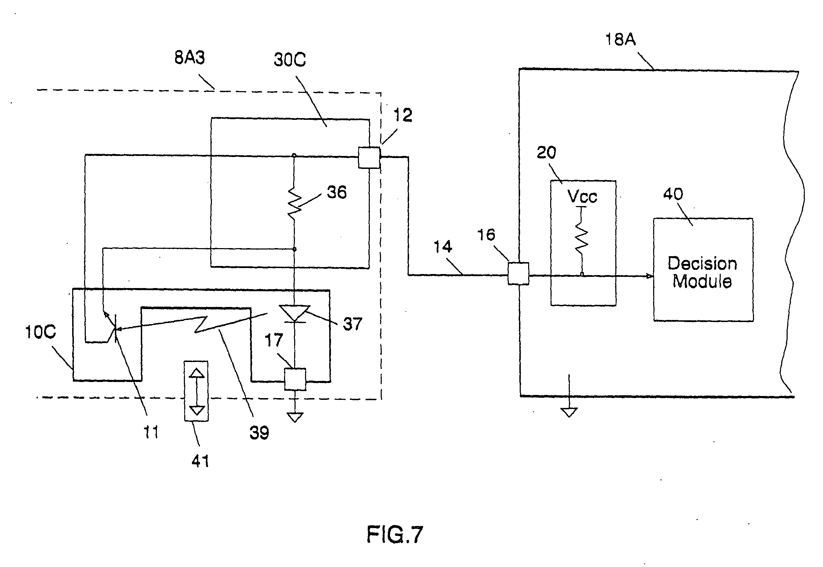

The third example of Fig.7 describes the interconnection of controller 18A and another embodiment of a peripheral device 8A3, based on a photo-interrupter such as SHARP GP1 L57. The 3-wire photo- interrupter 10C consists of a light emitting photo-diode 37 and phototransistor assembly 11, the phototransistor is intended to react to optical power 39 emitted by the photo diode 37. If the optical power path 39 is interrupted by an external object 41, the phototransistor 11 goes into the OFF state, while if not interrupted, then the phototransistor 11 is in the ON state.

The voltage divider 30C in this case consists of resistor 36 and emitting diode 37 connected in series. The current flowing through the interconnection line 14 will be determined by Vcc and pull-up resistor 20, resistor 36 and emitting diode 37 and transistor 11. In a preferred embodiment resistor 36 is 10KOhms and pull-up resistor 20 is 2.5KOhms.

If the optical path 39 from emitting diode 37 to phototransistor 11 is "uninterrupted", than even a relatively small current will cause diode 37 to emit enough optical energy, which results in increasing phototransistor 11 current (or decreasing the phototransistor's resistance), which in turn further decreases the resistance value of parallel resistor 36 and phototransistor 11. This lower resistance causes an increase of diode 37 current, which causes a further decrease of phototransistor 11 emitter-collector resistance, and so on, up to a steady state. The resulting voltage on the interconnection line 14 will be defined by diode 37 and the collector - emitter voltage drop of the ON state photo transistor 11 (Approximately 1.8 - 2.5 V). This voltage defines the minimum available voltage level 48 (Fig. 5) of such a peripheral device under the normal operation conditions.

"Interrupting" the optical path 39, between diode 37 and phototransistor 11, by an external object 41, will cause the phototransistor 11 to increase its resistance dramatically. The interconnection line current in this case will flow only through resistor 36. The voltage on the interconnection line 14 will be defined by diode 37, resistors 20 and 36. This voltage is the maximum available voltage level 42 (Fig. 5) of such a peripheral device under the normal conditions.

The detection of a disconnected or shorted to ground interconnection line 14 is performed exactly as described in the first example.

The physical embodiment of modules 30A, B, C can be done either by integration into digital detector 10A, B, C (on the same PCB or IC) respectively, or within the connector 12 of interconnection line 14.

The addition of modules 30A, B, C is not required where the peripheral device includes a built-in scaled output voltage range as described line 52 in Fig. 5.

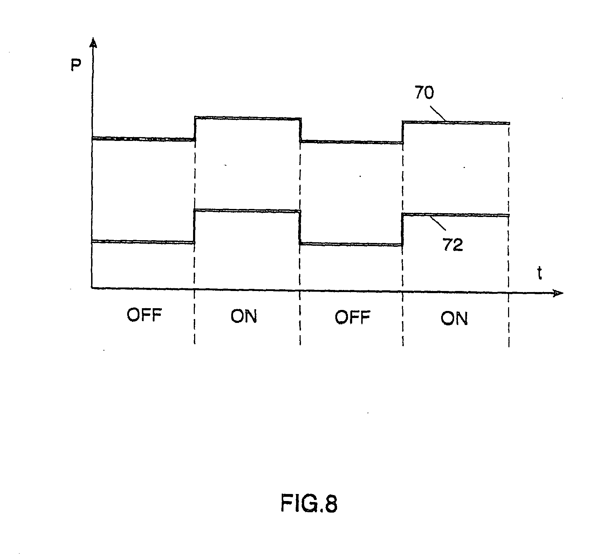

The proposed embodiment of peripheral device 8A in Fig. 7, is novel and presents additional new important features, including:
- A two-wire connections to the controller- namely device output 12 and ground 17- instead of three or four wire connections in conventional systems. This feature decreases the cost of the device, and increases reliability.
- Lower current consumption of the peripheral device.
   The explanatory timing diagram of Fig.8 shows the comparison of power consumption by the proposed circuitry of Fig.7 to a conventional peripheral device configuration (for example as shown in Fig.22 of OMRON's Technical Information document:
   **http://oeiwcsnts1.omron.com/pdfcatat.nsf/PDFLookupBvUniauelD/24E2913B9 D8A035F86256CDE00617173/$File/C21NAReflnfo0203.pdf?OpenElement**
   The total power consumption 70 of a conventional peripheral device 10C is a sum of the power consumptions of the emitting LED 37 and phototransistor 11. The power consumed by the conventional peripheral device is determined by a permanent supply of relatively high current to the emitting diode 37, especially for wide gap interrupters. The phototransistor's portion of power consumption is determined by the phototransistor current, which varies depending on the position of detected object 41- the phototransistor power consumption is small while the phototransistor is in its Off state, and is growing when the phototransistor is in its On state. The diagram 70 represents the total power consumption of the conventional detector.
   The peripheral device 8A3, based on the same detector but assembled according to the proposed scheme of fig.7, will not need the permanent supply of relatively high current to the emitting diode 37. Due to the series connection of emitting diode 37 and phototransistor 11 with resistors 36 and 20, the resulting steady state ("uninterrupted") current, as explained above, will be substantially reduced. In the "Interrupting" state, the current through photodetector 11 is anyway low, and the current through diode 37 is limited by pull-up resistor 20. The diagram line 72 of Fig.8 shows the total power of the proposed peripheral device 8, while in the On and Off states. Power line 72 is evidently lower than the conventional power line 70.
- Sharp logic transitions due to a built-in hysteresis effect.

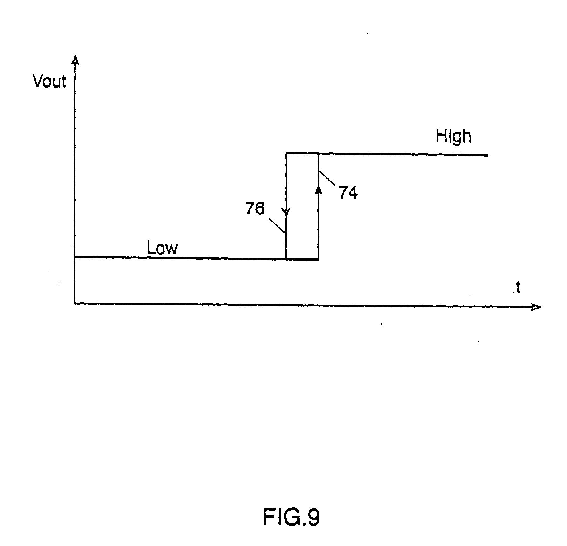

The dependence of LED 37 current on the optical energy received by phototransistor 11 results in a bi-stable hysteresis effect, demonstrated in Fig.9. The arrow on diagram line 74 shows the "low to high" logic transition and the arrow on line 76 shows the "high to low" logic transition. This inherent feature of the proposed peripheral device 8A3 eliminates the use of the "chattering" output prevention circuit components (as per the above mentioned OMRON's Technical Information document Figs 24 -26).

The novel circuit design concept, suitable for large verity of peripheral devices, improves significantly the diagnostics, of a previously weak link in the operation of controllers, coupled to peripheral devices. Diagnostic of the interconnection line 14 is now clear-cut, with minimal ambiguous results. The additional circuitry to be added in or at the output of the conventional digital detector is minimal and easily applicable. Additional benefits of fewer connection wires, lower overall power consumption, and better defined logic levels, are a bonus to the improved diagnostics.

While the invention has been described with respect to three preferred embodiments, it will be appreciated that this is set forth purely for purposes of example, and that many other variations, modifications and applications of the invention may be made.

## Claims

1. Apparatus for digital detection of relative position between two objects, coupled to an electronic controller, comprising:
a photo-transistor, a light-emitting diode and a resistor connected to form an electronic circuit, wherein said photo-transistor and said light emitting diode are physically separated but optically coupled;
means for interrupting said optical coupling;
a two-line connection to a decision module of said electronic controller,
wherein said decision module can verify the state of the line interconnect between said apparatus and said electronic controller to be one of states Logic High, Logic Low, Disconnected Line and Shorted Line.

2. The apparatus of claim 1, wherein said phototransistor is substantially connected in parallel to said resistor and said resistor is substantially connected in series with said light-emitting diode.

3. The apparatus of claim 1, wherein said line states Logic High, Logic Low correspond to the interruption or non-interruption of said optical coupling, and line states Disconnected Line and Shorted Line correspond to line faults.
